Europäisches Patentamt

European Patent Office

Office européen des brevets

(19)

(11) Numéro de publication: **0 012 663**
**B1**

(12) **FASCICULE DE BREVET EUROPEEN**

(45) Date de publication du fascicule du brevet: **09.11.83**

(21) Numéro de dépôt: **79400956.3**

(22) Date de dépôt: **04.12.79**

(51) Int. Cl.³: **G 11 C 11/40,**
G 11 C 11/24, G 11 C 11/34

(54) **Dispositif de réduction du temps d'accès aux informations contenues dans une mémoire d'un système de traitement de l'information.**

(30) Priorité: **06.12.78 FR 7834414**

(43) Date de publication de la demande:
**25.06.80 Bulletin 80/13**

(45) Mention de la délivrance du brevet:
**09.11.83 Bulletin 83/45**

(84) Etats contractants désignés:
**DE GB IT**

(56) Documents cités:
**US - A - 3 428 951**
**US - A - 3 801 965**

(73) Titulaire: **COMPAGNIE INTERNATIONALE POUR L'INFORMATIQUE CII - HONEYWELL BULL (dite CII-HB)**
**94, avenue Gambetta**
**F-75020 Paris (FR)**

(72) Inventeur: **Girard, Paul, Marie**
**2 bis, rue de Savoie**
**F-78000 Versailles (FR)**

(74) Mandataire: **Doireau, Marc**
**CII-Honeywell Bull Division Propriété Industrielle**
**94, avenue Gambetta Boîte Postale 33**
**F-75960 Paris cedex 20 (FR)**

Courier Press, Leamington Spa, England.

Dispositif de réduction du temps d'accès aux informations contenues
dans une mémoire d'un système de traitement de l'information

L'invention s'applique au domaine des techniques des traitements de l'information. Plus particulièrement, elle intervient au niveau des dispositifs de lecture des systèmes de mémoire, qu'il s'agisse des mémoires centrales de travail ou des mémoires de commande microprogrammées des ordinateurs. L'ensemble des opérations nécessaires à l'extraction d'une information du système de mémoire ont lieu séquentiellement dans le temps et font partie de ce qui est appelé le "cycle de lecture" du système de mémoire. La technique actuellement connue pour recueillir les informations issues d'un ensemble de mémoires consiste à placer un registre en sortie de ces dits ensembles. Ce registre, encore appelé registre de données ou d'instructions, est soit à horloge, soit à verrouillage. Dans le premier cas, les informations d'entrée issues du système de mémoire pénètrent dans le registre à l'apparition d'un signal d'horloge. Dans le second cas, les informations d'entrée du registre le traversent et sont figées dans l'état logique qu'elles présentent au moment où est mis au travail un signal de commande de verrouillage.

Un des paramètres très important qui caractérise les performances d'un système de mémoire est ce que l'on appelle son temps d'accès. C'est le temps qui s'écoule entre la présentation à l'ensemble de mémoire des signaux dits d'adressage qui définissent la zone de mémoire consultée et la mise à la disposition du processeur des signaux d'information issus de cet ensemble de mémorisation. Or, dans la disposition habituelle ce temps d'accès est manifestement affecté par la présence d'un registre de sortie dit registre d'informations destiné à recueillir les signaux de sortie de l'ensemble de mémoires. En effet, les signaux de sortie sont fugitifs par rapport à la durée d'utilisation généralement requise par le processeur. Ou bien les dispositifs de mémorisation offrent naturellement des signaux de durée limitée, ou bien leur maintien est asservi à un signal de commande dont la durée est elle-même limitée soit pour des raisons technologiques soit pour enchaîner plus rapidement d'autres opérations.

Le but de l'invention est donc de réduire le temps d'accès et par conséquent de l'améliorer en extrayant le registre d'informations de la chaîne des organes mis en cascade entre les signaux d'adressage à l'entrée des systèmes de mémoire et les signaux d'information à utiliser en sortie.

Ce principe est appliqué dans le brevet US 3 428 951 qui décrit un dispositif pour accélérer le transfert d'informations d'adresses transmises par un périphérique à une mémoire. Normalement, les informations transmises transitent par un registre intermédiaire qui mémorise ces informations avant d'être réellement utilisées. Le principe consiste à monter ce registre non plus en série, mais en parallèle, c'est-à-dire que les informations sont directement utilisées pour accélérer leur transmission tout en étant mémorisées dans le registre intermédiaire.

Selon l'invention il a été conçu un dispositif qui ne se distingue du brevet US précité que par la façon dont le principe est mis en oeuvre.

L'invention propose donc un dispositif de réduction du temps d'accès aux informations contenues dans un système de mémoire d'un système de traitement de l'information, ledit système de mémoire comprenant plusieurs blocs de mémoire pouvant contenir plusieurs bits d'informations associés à des moyens de lecture desdits bits d'informations contenus dans chaque bloc mémoire, ces bits d'information lus étant directement reçus sur une entrée d'un circuit d'utilisation pour accélérer leur transmission tout en étant mémorisés dans un registre, caractérisé en ce que ledit registre possède au moins deux entrées et une sortie et est composé d'un premier circuit inverseur recevant sur son entrée ou première entrée du registre un bit d'information lu dans l'un des blocs de mémoire, sa sortie étant reliée à une entrée d'une porte "NON-ET" à deux entrées, la deuxième entrée ou deuxième entrée du registre recevant un signal d'initialisation au début d'un cycle de lecture desdits blocs de mémoire, la sortie de ladite porte "NON-ET" étant reliée à l'entrée du premier inverseur, la sortie de ladite porte "NON-ET" et l'entrée dudit premier inverseur étant directement reliées à une entrée d'un circuit d'utilisation (3) des bits d'informations lus.

L'invention sera mieux comprise à l'aide de la description et des dessins qui vont suivre.

La figure 1 représente une disposition du système de mémoire illustrant le principe de l'invention tel qu'il est connu du brevet antérieur US précité.

La figure 2 est une représentation détaillée d'un système de mémoire incorporant le dispositif de réduction du temps d'accès à la mémoire selon l'invention.

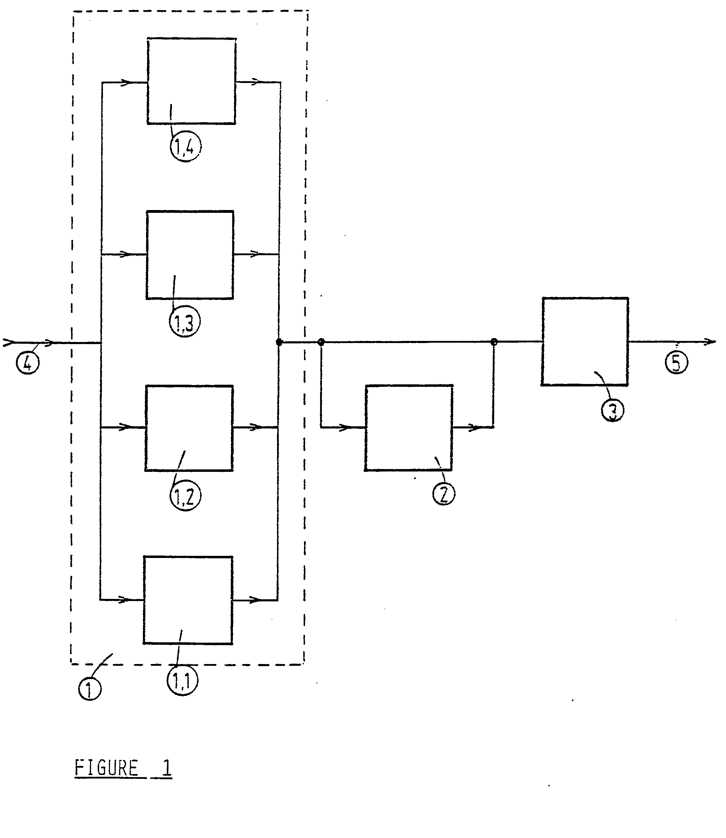

Dans la disposition telle que celle représentée à la figure 1 les informations contenues dans un ensemble de mémoires telles que 1 sont à adresser à partir de signaux d'adressage et de commande 4 puis restituer dans un registre d'informations 2. Le registre d'informations 2 peut être lié ensuite à un dispositif d'émission 3 des informations contenues dans le registre 2. Par conséquent comme il apparaît sur la figure 1, le principe de l'invention tel qu'il est connu de l'antériorité précitée va consister à relier l'entrée et la sortie du registre d'informations 2 par une liaison unique qui fera communiquer à la fois l'entrée et la sortie du registre 2 et la sortie de l'ensemble de mémoires avec l'entrée du dispositif d'émission 3. L'organe d'émission n'est pas nécessaire si l'utilisation des signaux d'informations ne s'effectue pas à distance du système de mémoire. La nécessité ou non de l'organe d'émission est définie par les règles d'emploi de la technologie mise en oeuvre en fonction de la distance que doivent franchir les signaux d'information.

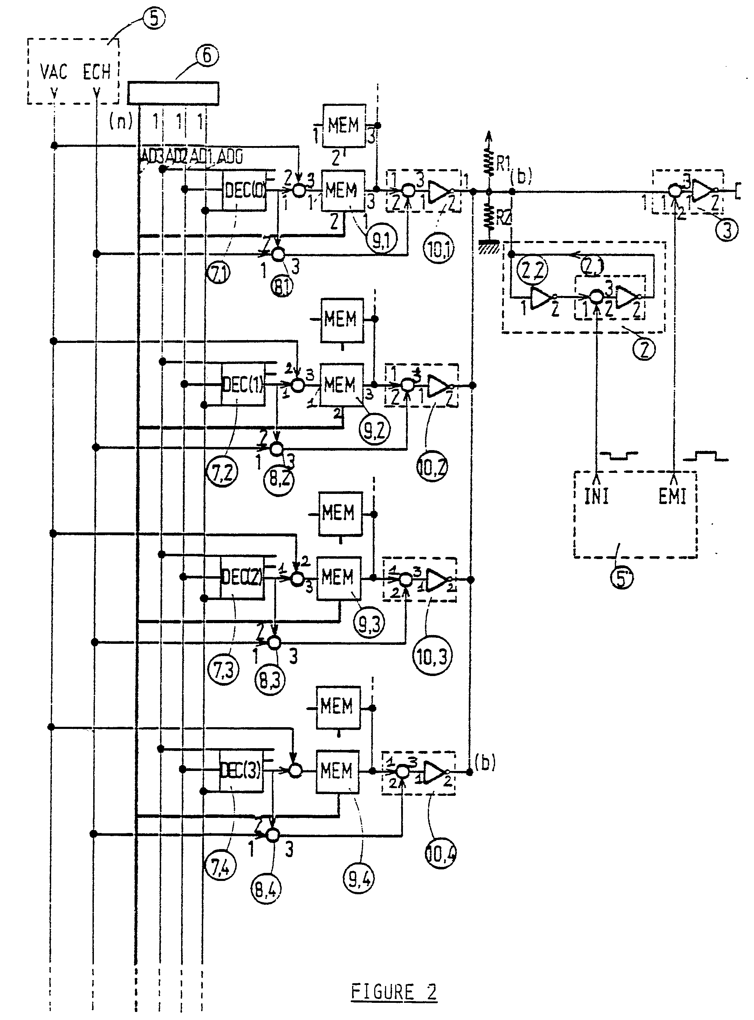

La figure 2 donne une représentation détaillée d'un système de mémoire incorporant le dispositif de réduction de temps d'accès à la mémoire selon l'invention.

Un organe de régulation figuré en traits pointillés en 5 et 5' fournit les signaux de commande qui vont animer l'ensemble. Ainsi qu'il l'a déjà été précisé plus haut un "cycle de lecture" est l'ensemble des opérations qui permettent d'extraire l'information du système de mémoire et de la présenter pendant le temps voulu au processeur. Au début du cycle de lecture, les signaux d'adressage ADO, AD1, AD2, AD3 à ADn sont présentés à l'ensemble de mémoire par le registre d'adresse 6. Certains d'entre eux, AD3 à ADn, accèdent directement aux circuits de mémoire marqués "MEM", et sélectionnent un cellule donnée à l'intérieur de ces circuits. Les autres, ADO, AD1, AD2 agissent sur des décodeurs marqués "DEC". La sortie convenable de ces décodeurs, différente pour chaque circuit de mémoire, conditionne le signal "VAC" de validation de circuit de mémoire issu de l'organe de régulation après stabilisation des signaux d'adressage. Ce signal "VAC" incite le circuit de mémoire choisi à délivrer sur sa sortie 3 un signal d'information au bout d'un temps propre de circuit.

Au début d'un cycle de mémoire sensiblement en même temps que le signal de commande "VAC", le signal d'initialisation "INI" qui sera par conséquent à "un logique" au repos et à zéro au travail, est issu de la zone de l'organe de régulation sous forme d'une impulsion calibrée en durée à la valeur logique zéro. Cette impulsion présente cette valeur zéro sur l'entree 2 de l'outil ET-NON 2,1 du registre d'informations 2. Quelle que soit la valeur de l'entrée 1, cette valeur logique zéro s'impose sur le circuit ET et délivre la valeur logique "un" après l'inversion du circuit NON de l'outil 2,1 sur la sortie 2 de cet inverseur. La valeur logique apparaît sur le fil (b) couplant les différents éléments de l'ensemble de mémoires. A cet instant, le signal de commande d'échantillonnage "ECH" est au repos, c'est-à-dire au niveau logique zéro. Ce niveau se propage à travers les circuit ET 8,1 8,2 8,3 8,4 etc... puis à travers les circuits ET des outils logiques ET-NON marqués 10,1 10,2 10,3 10,4 etc... pour donner après inversion dans l'inverseur de ces outils le niveau logique vrai (un) sur le fil (b). Le niveau "un", pris par conséquent par le fil (b), donne le niveau zéro à la sortie 2 de l'inverseur 2,2 du registre d'informations 2. Ce niveau zéro vient donc confirmer l'état "zéro" sur le circuit ET et ainsi la valeur "un" à la sortie sur le fil (b) du registre d'informations. Il a été procédé ainsi à l'initialisation à la valeur logique "un" du registre d'informations. En effet, si sa valeur était zéro, donnant "un" logique sur l'entrée 1 du circuit ET de l'outil 2,1 la commande d'initialisation INI aurait imposé sa valeur "zéro" qui comme on l'a vu se maintiendra sur cet outil après rebouclage par l'inverseur 2,2 maintenant ainsi la valeur "un" en sortie sur le fil (b) du registre d'informations.

Les outils 2,1 10,1 10,2 etc... sont des circuits à collecteurs ouverts, ce qui implique la présence du réseau de résistance R1, R2 sur le fil (b). L'ensemble des signaux logiques alimentant le fil (b) fonctionne en ET cablé. Un seul d'entre eux à la valeur logique "zéro" impose cette valeur zéro sur le fil (b).

Quatre sous-ensembles de mémoire comportant un décodeur "DEC" 7,1 à 7,4, un ou plusieurs circuits de mémoire "MEM" 9,1 à 9,4 et leurs outils logiques associés ont été représentés sur la figure 2. Il est possible de connecter sur le fil (b) plusieurs sous-ensembles de ce type chaque sous-ensemble sera alors sélectionné par le décodeur "DEC". Il sera aussi possible à l'aide d'une couche supplémentaire de décodeurs non représentés sur la figure 2 de connecter plusieurs circuits de mémoire sur l'entrée 1 de l'outil ET des portes 10,1 à 10,4. Le signal de validation de circuit "VAC" émis par l'organe de régulation 5 est conditionné par les décodeurs "DEC" de sorte qu'un seul circuit de mémoire "MEM" puisse fournir une valeur de sortie. A l'instant où le circuit de mémoire "MEM" sélectionné délivre son signal d'information sur sa sortie 3, le signal de commande d'échantillonnage "ECH" émis par l'organe de régulation 5 est mis au travail c'est-à-dire à la valeur logique 1. Il apparaît sur l'entrée 1 du circuit ET, 8,1 8,2 etc... seul, le circuit ET qui reçoit du décodeur "DEC" correspondant une validation à "un" sur son entrée 2 délivre un signal de commande sur validation à "un" sur son entrée 2 délivre un signal de commande sur sa sortie 3. Ce signal de commande vient valider sur l'entrée du circuit ET de l'outil 10 le signal d'information entrant en 1 et issu du circuit de mémoire "MEM" sélectionné. Les circuits de mémoire "MEM" contiennent la valeur logique complémentée. Si la valeur issue du boitier de mémoire "MEM" est "zéro" correspondant à une information à la valeur logique "un", ce zéro s'impose sur le circuit ET de l'outil 10 correspondant et se transforme après inversion en la valeur logique "un" sur le fil (b). Le registre d'information 2 n'est pas modifié et cette valeur est immédiatement disponible sur l'entrée 1 de l'outil ET-NON d'émission marqué 3. Le temps de traversée du registre d'information a donc été gagné, ce qui réduit le temps d'accès d'autant. Cette information se maintient évidemment après la fin d'échantillonnage. Si par contre, la valeur issue du boitier de mémoire "MEM" est à "un" correspondant à une information à la valeur logique "zéro", la sortie 3 du circuit et de l'outil 10 correspondant prend la valeur "un" pendant la durée du signal d'échantillonnage. Cela impose la valeur "zéro" en sortie de l'inverseur de ce même outil 10 et par suite, cette valeur zéro sur le fil (b). Là encore, l'information est immédiatement disponible sur le fil (b) sans traversée du registre d'information qui reçoit en parallèle cette même valeur "zéro" sur l'entrée 1 de son inverseur 2,2. Après inversion due à cet inverseur, la valeur "un" apparaît à l'entrée 1 du circuit ET de l'outil 2,1. Comme le signal de commande d'initialisation INI est au repos, c'est-à-dire à la valeur logique "un", la sortie 3 du circuit ET de l'outil 2,1 prend la valeur "un" confirmant après inversion par l'inverseur du circuit 2,1 la valeur "zéro" sur le fil (b). Cette valeur est maintenue par le bouclage à travers l'inverseur 2,2 et le circuit 2,1 du registre d'information 2. Après disparition du signal d'échantillonnage "ECH", c'est donc le registre d'information 2 qui assure la valeur "zéro" sur le fil (b). Comme dans le cas précédant le temps de traversée du registre d'information a également été évité.

**Revendication**

Dispositif de réduction du temps d'accès aux informations contenues dans un système de mémoire d'un système de traitement de l'information, ledit système de mémoire comprenant plusieurs blocs de mémoire pouvant contenir plusieurs bits d'informations associés à des moyens de lecture desdits bits d'informations contenus dans chaque bloc mémoire, ces bits d'information lus étant directement reçus sur une entrée d'un circuit d'utilisation (3) pour accélérer leur transmission tout en étant mémorisés dans un registre (2), caractérisé en ce que ledit registre (2) possède au moins deux entrées et une sortie et est composé d'un premier circuit inverseur (2,2) recevant sur son entrée ou première entrée du registre (2) un bit d'information lu dans l'un des blocs de mémoire, sa sortie étant reliée à une entrée d'une porte "NON-ET" (2,1) à deux entrées, la deuxième entrée ou deuxième entrée du registre recevant un signal d'initialisation (INI) au début d'un cycle de lecture desdits blocs de mémoire (MEM), la sortie de ladite porte "NON-ET" (2,1) étant reliée à l'entrée du premier inverseur (2,2), la sortie de ladite porte "NON-ET" (2,1) et l'entrée dudit premier inverseur (2,2) étant directement reliées à une entrée d'un circuit d'utilisation (3) des bits d'informations lus.

**Patentanspruch**

Vorrichtung zur Verkürzung der Zugriffzeit zu den Informationen, die in eimem Speichersystem eines Informationsverarbeitungssystems enthalten sind, wobei das Speichersystem eine Mehrzahl von Speicherblöcken enthält, die eine Mehrzahl von Informationsbits enthalten können, und denen Leseeinrichtungen zum Auslesen dieser Informationsbits zugeordnet sind, die in jedem Speicherblock enthalten sind, wobei diese ausgelesenen Informsationsbits direkt an einem Eingang einer Verwertungsschaltung (3) empfangen werden, um ihre Übertragung zu beschleunigen, während sie in einem Register (2) gespeichert sind, dadurch gekennzeichnet, daß das Register (2) wenigstens zwei Eingänge und einen Ausgang aufweist und zusammengesetzt ist aus einer ersten Inverterschaltung (2,2), die an ihrem Eingang bzw. an dem ersten Eingang des Registers (2) ein Informationsbit empfängt, das aus einem der Speicherblöcke ausgelesen wird, wobei sein Ausgang an den ersten Eingang einer NAND-Schaltung (2,1) angeschlossen ist, die zwei Eingänge aufweist, während der zweite Eingang bzw. der zweite Eingang des Registers ein Initierungssignal (INI) am Anfang eines Lesezyklus zum Auslesen aus den Speicherblöcken (MEM) empfängt und der Ausgang der NAND-Schaltung (2,1) mit dem Eingang des ersten Inverters (2,2) verbunden ist, wobei der Ausgang der NAND-Schaltung (2,1) und der Eingang des ersten Inverters (2,2) direkt mit einem Eingang einer Verwertungsschaltung (3) zum Verwerten der ausgelesenen Informationsbits verbunden sind.

**Claim**

Device for the reduction of the access time to the data contained in a memory system of a data processing system, the said memory system comprising several memory blocks which may contain several bits of data associated with means for reading the said bits of data contained in each memory block, these data bits which are read being directly received on one input of a utilization circuit (3) in order to accelerate their transmission whilst being memorised in a register (2), characterised in that the said register (2) possesses at least two inputs and an output and is composed of a first inverter circuit (2,2) receiving on its input or first input of the register (2) a data bit read in the one of the memory blocks, its output being connected to one input of a NAND gate (2,1) having two inputs, the second input or second input of the register receiving an initiating signal (INI) at the start of a read cycle of the same memory blocks (MEM), the output of the said NAND gate (2,1) being connected to the input of the first inverter (2,2), the output of the said NAND gate (2,1) and the input of the said inverter (2,2) being directly connected to an input of a utilization circuit (3) of the data bits read.

FIGURE 1

0 012 663

FIGURE 2